# EUROPEAN PATENT APPLICATION

(11) **EP 4 393 697 A1**
(43) Date of publication of application: **03.07.2024**
(21) Application number: 22860942.6
(22) Date of filing: 16.06.2022
(51) Int. Cl.: B32B 9/00

(54) **GAS BARRIER MULTILAYER FILM**

(30) Priority: 23.08.2021 JP 2021135891
(71) Applicant: Toyo Seikan Group Holdings, Ltd., Shinagawa-ku Tokyo 141-8627 (JP)
(72) Inventor: OBU, Yusuke, Tokyo 141-8627 (JP); HAYASHI, Kenji, Tokyo 141-8627 (JP)
(74) Representative: J A Kemp LLP
(86) International application number: PCT/JP2022/024152
(87) International publication number: WO 2023/026648

(57) **Abstract**

The present invention provides a gas barrier multilayer film including a substrate layer (A1), a moisture trapping layer (B1), and an outer layer (Q) in this order, in which the substrate layer (A1) has a layer selected from the group consisting of an inorganic barrier layer (a1) and an inorganic barrier layer (a2) on at least one surface of a plastic layer (x), and the substrate layer (A1) has a moisture permeability (40°C, RH90%) of less than 1 × 10⁻³ g/m²/day.

## Description

### Technical Field

The present invention relates to a gas barrier multilayer film to be used as a sealing material or a substrate of an electronic device represented by an organic electroluminescence (EL) element, a solar cell, or the like.

### Background Art

Various electronic devices that have been developed and put to practical use in recent years, for example, organic electroluminescence (organic EL), a solar cell, a touch panel, an electronic paper, and the like are required to have a high moisture barrier property to avoid charge leakage and the like due to moisture.

As a means for improving properties of various plastic substrates, particularly a gas barrier property, it has been known to form an inorganic thin film (inorganic barrier layer) made of silicon oxide or the like on a surface of a plastic substrate by vapor deposition (Patent Document 1), and a film including such an inorganic thin film has been widely used as a barrier film. Such a barrier film is insufficient to satisfy the moisture barrier property required for an electronic device as described above, and residual moisture of a resin used for the plastic substrate remarkably deteriorates the device.

In order to satisfy such requirements, there is also known a moisture barrier laminate having a structure in which a moisture trapping layer including an ionic polymer having hygroscopicity as a matrix is laminated (Patent Document 2).

The moisture trapping layer as described above is formed by applying a coating composition for forming a trapping layer including an ionic polymer onto an inorganic barrier layer formed on a surface of a plastic film by vapor deposition or the like and curing the coating composition. An excellent moisture barrier property is exhibited by formation of such a layer.

However, the moisture barrier property of the inorganic barrier layer is insufficient, and thus a sufficient moisture barrier property as a sealing material for an electronic device has not been yet secured, whereby the problem remains unsolved.

### Citation List

### Patent Literature

Patent Document 1: JP 2000-255579 A
Patent Document 2: JP 2015-96320 A

### Summary of Invention

### Technical Problem

Accordingly, an object of the present invention is directed to providing a multilayer film exhibiting a sufficient moisture barrier property as a sealing material for an electronic device.

### Solution to Problem

The present invention includes the following inventions.
1. A gas barrier multilayer film including:
   a substrate layer (A1), a moisture trapping layer (B1), and an outer layer (Q) in this order, in which
   the substrate layer (A1) has a layer selected from the group consisting of an inorganic barrier layer (a1) and an inorganic barrier layer (a2) on at least one surface of a plastic layer (x), and
   the substrate layer (A1) has a moisture permeability (40°C, RH90%) of less than 1 × 10⁻³ g/m²/day.
2. The gas barrier multilayer film according to the above item 1, in which
   the substrate layer (A1) includes
   (α) an inorganic barrier layer (a1) on a surface remote from the moisture trapping layer (B1),
   (β) an inorganic barrier layer (a2) on a surface adjacent the moisture trapping layer (B1), or
   (γ) the (α) and the (β).
3. The gas barrier multilayer film according to the above item 1 or 2, in which the outer layer (Q) is a layer selected from the group consisting of a plastic layer (C), the substrate layer (A1) and a substrate layer (A2), and the substrate layer (A2) is a layer having an inorganic barrier layer (a4) on one surface of the plastic layer (y).
4. The gas barrier multilayer film according to the above item 1 or 2, further including a moisture trapping layer (B2) on a surface of the substrate layer (A1) remote from the moisture trapping layer (B1).
5. The gas barrier multilayer film according to the above item 4, further including an adhesive layer (D) and a substrate layer (A3) in this order on a surface of the moisture trapping layer (B2) remote from the substrate layer (A1), in which the substrate layer (A3) is a layer having an inorganic barrier layer (a5) on one surface of a plastic layer (z).
6. The gas barrier multilayer film according to any one of the above items 1 to 5, further including an inorganic barrier layer (a3) on a surface of the plastic layer (C) adjacent the moisture trapping layer (B1).
7. The gas barrier multilayer film according to any one of the above items 1 to 6, further including an adhesive layer (D) on a surface of the moisture trapping layer (B1) adjacent the outer layer (Q).
8. The gas barrier multilayer film according to any one of the above items 1 to 7, in which the inorganic barrier layers (a1) to (a5) are metal oxide films.
9. The gas barrier multilayer film according to any one of the above items 1 to 8, in which the plastic layers (x) to (z) include an olefin-based resin, a polyester resin, a polyimide resin, a polyamide resin, or a cyclic olefin-based resin.
10. The gas barrier multilayer film according to any one of the above items 1 to 9, in which both the moisture trapping layer (B1) and the moisture trapping layer (B2) contain a resin composition in which a moisture absorbing agent (ii) is dispersed in an ionic polymer (i).
11. The gas barrier multilayer film according to any one of the above items 1 to 10, in which the plastic layer (C) includes an olefin-based resin, a polyester resin, a polyimide resin, a polyamide resin, or a cyclic olefin-based resin.

### Advantageous Effects of Invention

The gas barrier multilayer film of the present invention has an excellent moisture barrier property.

### Brief Description of Drawings

FIG. 1 is a schematic cross-sectional side view illustrating a layer structure of a multilayer film 1 of Example 1.
FIG. 2 is a schematic cross-sectional side view illustrating a layer structure of a multilayer film 2 of Example 2.
FIG. 3 is a schematic cross-sectional side view illustrating a layer structure of a multilayer film 3 of Example 3.
FIG. 4 is a schematic cross-sectional side view illustrating a layer structure of a multilayer film 4 of Example 4.
FIG. 5 is a schematic cross-sectional side view illustrating a layer structure of a multilayer film 5 of Example 5.
FIG. 6 is a schematic cross-sectional side view illustrating a layer structure of a multilayer film 6 of Comparative Example 1.

### Description of Embodiments

A multilayer film of the present invention is a gas barrier multilayer film including:
a substrate layer (A1), a moisture trapping layer (B1), and an outer layer (Q) in this order, in which
the substrate layer (A1) has a layer selected from the group consisting of an inorganic barrier layer (a1) and an inorganic barrier layer (a2) on at least one surface of a plastic layer (x), and
the substrate layer (A1) has a moisture permeability (40°C, RH90%) of less than 1 × 10⁻³ g/m²/day.

### Substrate Layer (A1)

The substrate layer (A1) has a layer selected from the group consisting of the inorganic barrier layer (a1) and the inorganic barrier layer (a2) on at least one surface of the plastic layer (x).

### Plastic Layer (x)

The plastic layer (x) serves as a base of the inorganic barrier layer (a1) and the inorganic barrier layer (a2) described below, and is usually molded by injection or co-injection molding, extrusion or co-extrusion molding, film or sheet molding, compression molding, cast polymerization, or the like, depending on the form, using a thermoplastic or thermosetting resin.

The plastic layer (x) is preferably formed of a thermoplastic resin from the viewpoint of moldability, cost, and the like. Examples of such a thermoplastic resin include: polyolefins such as low-density polyethylene, high-density polyethylene, polypropylene, poly-1-butene, poly-4-methyl-1-pentene, and random or block copolymers of α-olefins such as ethylene, propylene, 1-butene, and 4-methyl-1-pentene; cyclic olefin-based resins such as cycloolefin copolymers and cycloolefin polymers; ethylene-vinyl compound copolymers such as ethylene-vinyl acetate copolymers, ethylene-vinyl alcohol copolymers, and ethylene-vinyl chloride copolymers; styrene-based resins such as polystyrene, acrylonitrile-styrene copolymers, ABS, and α-methylstyrene-styrene copolymers; polyvinyl compounds such as polyvinyl chloride, polyvinylidene chloride, vinyl chloride-vinylidene chloride copolymers, polymethyl acrylate, and polymethyl methacrylate; polyamides such as nylon 6, nylon 6-6, nylon 6-10, nylon 11, and nylon 12; thermoplastic polyesters such as polyethylene terephthalate (PET), polybutylene terephthalate, and polyethylene naphthalate (PEN); polycarbonates; polyphenylene oxides; polyimide resins; polyamide-imide resins; polyetherimide resins; fluororesins; allyl resins; polyurethane resins; cellulose resins; polysulfone resins; polyethersulfone resins; ketone resins; amino resins; and biodegradable resins such as polylactic acid. In addition, the thermoplastic resin may be a blend of the resins exemplified above, or a resin produced by appropriately modifying any of these resins by copolymerization (for example, an acid-modified olefin resin).

The plastic layer (x) preferably includes an olefin-based resin, a polyester resin, a polyimide resin, a polyamide resin, or a cyclic olefin-based resin.

The plastic layer (x) is also suitably formed of a gas barrier resin or the like having an excellent oxygen barrier property such as an ethylene-vinyl alcohol copolymer, and may have a multilayer structure including a layer formed of such a gas barrier resin.

From the viewpoint that the plastic layer (x) is suitable as a base of the inorganic barrier layer (a) described below, a film of a polyester resin such as polyethylene terephthalate (PET), polybutylene terephthalate, or polyethylene naphthalene carboxylate, a polyimide resin, a polyamide resin, or a cyclic olefin-based resin such as a cyclic olefin copolymer or a cyclic olefin polymer is more suitably used as the plastic layer (x).

A thickness of the plastic layer (x) is not particularly limited, but when the thickness is excessively large, an amount of residual moisture in the plastic layer (x) increases. In addition, flexibility of the gas barrier multilayer film is lost, and thus the thickness of the plastic layer (x) is preferably 200 µm or less, more preferably 125 µm or less, and still more preferably 45 µm or less.

### Inorganic Barrier Layer (a1), Inorganic Barrier Layer (a2)

The substrate layer (A1) has an inorganic barrier layer on at least one surface of the plastic layer (x). The substrate layer (A1) has an aspect α, an aspect β, or an aspect γ as follows.

In the aspect α, the substrate layer (A1) has the inorganic barrier layer (a1) on a surface remote from the moisture trapping layer (B1).

In the aspect β, the substrate layer (A1) has the inorganic barrier layer (a2) on a surface adjacent the moisture trapping layer (B1).

In the aspect γ, the substrate layer (A1) includes the (α) and the (β), that is, the substrate layer (A1) has the inorganic barrier layer (a1) on the surface remote from the moisture trapping layer (B1) and the inorganic barrier layer (a2) on the surface adjacent the moisture trapping layer (B1).

The inorganic barrier layer (a1) and the inorganic barrier layer (a2) may be layers having the same properties and thickness, or may be layers having different properties and thicknesses.

In the present invention, the substrate layer (A1) has a moisture permeability (40°C, RH90%) of less than 1 × 10⁻³ g/m²/day, preferably less than 8 × 10⁻⁴ g/m²/day, and more preferably less than 5 × 10⁻⁴ g/m²/day.

In a case where the substrate layer (A1) has the inorganic barrier layer (a1) or the inorganic barrier layer (a2) on one surface of the plastic layer (x), the substrate layer (A1) has a moisture permeability (40°C, RH90%) of preferably less than 1 × 10⁻³ g/m²/day, more preferably less than 8 × 10⁻⁴ g/m²/day, and still more preferably less than 5 × 10⁻⁴ g/m²/day.

In a case where the substrate layer (A1) has the inorganic barrier layer (a1) on one surface of the plastic layer (x) and the inorganic barrier layer (a2) on the other surface thereof, the substrate layer (A1) has a moisture permeability (40°C, RH90%) of preferably less than 8 × 10⁻⁴ g/m²/day, more preferably less than 5 × 10⁻⁴ g/m²/day, and still more preferably less than 3 × 10⁻⁴ g/m²/day.

Each of the inorganic barrier layer (a1) and the inorganic barrier layer (a2) is a layer formed using the plastic layer (x) as a base. The inorganic barrier layers (a) are each preferably a film formed by vapor deposition or a film formed by wet coating. Examples of the film formed by vapor deposition include an inorganic or inorganic-organic hybrid vapor-deposited film formed by techniques such as physical vapor deposition represented by sputtering, vacuum vapor deposition, or ion plating, or chemical vapor deposition represented by plasma CVD. Examples of the film formed by wet coating include an inorganic or inorganic-organic hybrid coating film formed by a sol-gel process.

It is suitable that each of the inorganic barrier layer (a1) and the inorganic barrier layer (a2) is a film formed of various metals, metal oxides, or metal oxides containing an organic substance from the viewpoint that a high oxygen barrier property can be secured. In particular, from the viewpoint that a film is uniformly formed on a surface having irregularities and excellent barrier properties against not only oxygen but also moisture are exhibited, it is preferable that the inorganic barrier layers be formed by plasma CVD or a sol-gel process. The inorganic barrier layer (a1) and the inorganic barrier layer (a2) are preferably metal oxide films or metal oxide films containing an organic substance.

The vapor-deposited film formed by plasma CVD is produced by: disposing the plastic layer (x) having a film shape and serving as a base of the inorganic barrier layer (a1) and the inorganic barrier layer (a2) in a plasma treatment chamber held at a predetermined vacuum degree; supplying, by using a gas supply tube, a metal forming a film or a gas (reaction gas) of a compound containing the metal and an oxidizing gas (usually a gas of oxygen or NOx), together with a carrier gas such as argon or helium if appropriate, to the plasma treatment chamber shielded by a metal wall and decompressed to a predetermined vacuum degree; generating glow discharge by a microwave electric field or a high-frequency electric field in this state; generating plasma by electric energy of the generated glow discharge; and depositing a decomposition reaction product of the compound on the surface of the plastic layer (x) to form a film.

As the reaction gas, a gas of an organometallic compound is used in general, from the viewpoint that the organometallic compound can form a film having a flexible region containing a carbon component at the interface with the plastic layer (x) that is a base, and having a region having a high degree of oxidation and excellent barrier properties on the flexible region. Preferable examples of the organometallic compound include an organoaluminium compound such as trialkyl aluminum, an organotitanium compound, an organozirconium compound, and an organosilicon compound. In particular, from the viewpoint that the inorganic barrier layer (a1) and the inorganic barrier layer (a2) having a high barrier property against oxygen can be relatively easily and efficiently formed, the organosilicon compound is most preferable.

Examples of such an organosilicon compound include: organic silane compounds such as hexamethyldisilane, vinyltrimethylsilane, methylsilane, dimethylsilane, trimethylsilane, diethylsilane, propylsilane, phenylsilane, methyltriethoxysilane, vinyltriethoxysilane, vinyltrimethoxysilane, tetramethoxysilane, tetraethoxysilane, phenyltrimethoxysilane, methyltrimethoxysilane, and methyltriethoxysilane; and organic siloxane compounds such as octamethylcyclotetrasiloxane, 1,1,3,3-tetramethyldisiloxane, and hexamethyldisiloxane. In addition to these, aminosilane, silazane, or the like can also be used. The organometallic compounds described above can be used alone or in combination of two or more.

Thicknesses of the inorganic barrier layer (a1) and the inorganic barrier layer (a2) are set to satisfy a predetermined moisture permeability depending on the thickness of the plastic layer (x) serving as a base, and only required to be generally about 4 to 500 nm, and particularly about 30 to 400 nm.

The inorganic barrier layer (a1) and the inorganic barrier layer (a2) can also be formed on the plastic layer (x) by coating or the like without using a technique such as vapor deposition.

Typical examples of the inorganic barrier layers (a) formed by coating include those produced by applying, onto a predetermined surface, an organic solvent solution containing polysilazane, a polycondensable silane compound (for example, alkoxysilane and the like), and a polycondensable alumina compound (for example, alkoxyaluminum and the like) as a film-forming component with inorganic fine particles such as silica and alumina being appropriately mixed, heating, and volatilizing the organic solvent to form a film.

The inorganic barrier layers (a) may each have an anchor coat layer and a topcoat layer. Known techniques can be used for the anchor coat layer and the topcoat layer. For the anchor coat layer, for example, an acrylic resin, an epoxy resin, an acrylic urethane resin, a polyester-based polyurethane resin, or a polyether-based polyurethane resin can be used. From the viewpoint of adhesion and heat resistance, a polyester-based polyurethane resin or an acrylic urethane resin is desirable. For the topcoat layer, for example, polyvinyl alcohol, polyvinyl pyrrolidone, methyl cellulose, carboxymethyl cellulose, starch, sodium alginate, or a mixture thereof can be used. In the topcoat layer, an inorganic oxide may be mixed with the resin.

### Outer Layer (Q)

When the multilayer film of the present invention is attached to an electronic device, the outer layer (Q) is a layer remote from the electronic device. The outer layer (Q) is a layer selected from the group consisting of a plastic layer (C), the substrate layer (A1) and a substrate layer (A2). In the present invention, there is an aspect in which the same layer as the substrate layer (A1) is used as the outer layer (Q). That is, there is an aspect in which two same substrate layers (A1) are used. The substrate layer (A2) and the plastic layer (C) will be described below.

### Substrate Layer (A2)

The substrate layer (A2) has an inorganic barrier layer (a4) on one surface of a plastic layer (y).

In the present invention, as shown in (7) and (8) of the aspect γ described below, an adhesive layer (D) and the substrate layer (A2) can be further included in this order on a surface of the moisture trapping layer (B1) remote from the substrate layer (A1).

As a material and thickness of the plastic layer (y), those described in the section of the plastic layer (x) can be employed. The material and thickness of the plastic layer (y) may be the same as or different from those of the plastic layer (x).

As a property, material, thickness, and manufacturing method of the inorganic barrier layer (a4), those described in the section of the inorganic barrier layer (a1) and the inorganic barrier layer (a2) can be employed. The property, material, thickness, and manufacturing method of the inorganic barrier layer (a4) may be the same as or different from those of the inorganic barrier layer (a1) or the inorganic barrier layer (a2).

A moisture permeability (40°C, RH90%) of the inorganic barrier layer (a4) need not be necessarily less than 1 × 10⁻³ g/m²/day.

### Substrate Layer (A3)

A substrate layer (A3) has an inorganic barrier layer (a5) on one surface of a plastic layer (z).

In the present invention, as shown in (5) to (8) and (11) to (12) of the aspect γ described below, the adhesive layer (D) and the substrate layer (A3) are further included in this order on the surface of a moisture trapping layer (B2) described below remote from the substrate layer (A1), and the substrate layer (A3) can have an inorganic barrier layer (a5) on one surface of the plastic layer (z). (6) of the aspect γ is an aspect in which the substrate layer (A3) is reversed in (5). (8) of the aspect γ is an aspect in which the substrate layer (A3) is reversed in (7).

As a material and thickness of the plastic layer (z), those described in the section of the plastic layer (x) can be employed. The material and thickness of the plastic layer (z) may be the same as or different from those of the plastic layer (x).

As a property, material, thickness, and manufacturing method of the inorganic barrier layer (a5), those described in the section of the inorganic barrier layer (a1) and the inorganic barrier layer (a2) can be employed. The property, material, thickness, and manufacturing method of the inorganic barrier layer (a5) may be the same as or different from those of the inorganic barrier layer (a1) or the inorganic barrier layer (a2). A moisture permeability (40°C, RH90%) of the inorganic barrier layer (a5) need not be necessarily less than 1 × 10⁻³ g/m²/day.

### Inorganic Barrier Layer (a3)

There is an aspect in which the multilayer film of the present invention includes an inorganic barrier layer (a3), the inorganic barrier layer (a4), and the inorganic barrier layer (a5) other than the inorganic barrier layer (a1) and the inorganic barrier layer (a2) constituting the substrate layer (A1).

The inorganic barrier layer (a3) is a layer formed using the plastic layer (C) as a base.

The inorganic barrier layer (a3) can be formed on a surface of the plastic layer (C) adjacent the moisture trapping layer (B1).

The inorganic barrier layer (a3) may be of the same material as the inorganic barrier layer (a1) or the inorganic barrier layer (a2), and may have the same thickness as the inorganic barrier layer (a1) or the inorganic barrier layer (a2). The inorganic barrier layer (a3) can be formed by the same method as that of the inorganic barrier layer (a1) or the inorganic barrier layer (a2). The inorganic barrier layer (a) may have an anchor coat layer and/or a topcoat layer. Known techniques can be used for the anchor coat layer and the topcoat layer. For the anchor coat layer, for example, an acrylic resin, an epoxy resin, an acrylic urethane resin, a polyester-based polyurethane resin, or a polyether-based polyurethane resin can be used. From the viewpoint of adhesion and heat resistance, a polyester-based polyurethane resin or an acrylic urethane resin is desirable. For the topcoat layer, for example, polyvinyl alcohol, polyvinyl pyrrolidone, methyl cellulose, carboxymethyl cellulose, starch, sodium alginate, or a mixture thereof can be used. In the topcoat layer, an inorganic oxide may be mixed with the resin.

### Moisture Trapping Layer (B1)

In the present invention, the moisture trapping layer (B1) blocks moisture flowing in a thickness direction of the gas barrier multilayer film.

### Ionic Polymer

The moisture trapping layer (B1) is preferably formed of an ionic polymer. The moisture trapping layer (B1) is preferably formed by using an ionic polymer as a matrix, and dispersing a moisture absorbing agent having a lower ultimate humidity than that of the ionic polymer in the matrix. When an ionic polymer is used as a matrix, the moisture trapping layer has an excellent moisture trapping property, and when a moisture absorbing agent having a low ultimate humidity is further dispersed, the moisture absorbed by the ionic polymer can be transferred to the moisture absorbing agent to trap the absorbed moisture in the moisture absorbing agent, whereby the permeated moisture can be completely trapped in the trapping layer. In addition, deformation such as swelling caused by moisture absorption in the trapping layer can be effectively avoided.

Examples of the ionic polymer suitably used for forming the moisture trapping layer (B1) include a cationic polymer and an anionic polymer.

The cationic polymer is a polymer having, in the molecule, a cationic group that can be positively charged in water, for example, primary to tertiary amino groups, a quaternary ammonium group, a pyridyl group, an imidazole group, a quaternary pyridinium, or the like. Such a cationic polymer can form a matrix having hygroscopicity because the cationic group has a strong nucleophilic action and traps water by hydrogen bonding.

An amount of the cationic group in the cationic polymer may be generally such an amount that the water absorption rate (JIS K-7209-1984) of the polymer is 20% or more, particularly 30 to 45% under an atmosphere of a humidity of 80%RH and 30°C.

Usable examples of the cationic polymer include those produced by polymerizing or copolymerizing at least one of cationic monomers represented by: amine-based monomers such as allylamine, ethyleneimine, vinylbenzyltrimethylamine, [4-(4-vinylphenyl)-methyl]-trimethylamine, and vinylbenzyltriethylamine; nitrogen-containing heterocyclic monomers such as vinylpyridine and vinylimidazole; and salts thereof, together with another copolymerizable monomer if appropriate, and as necessary, partially neutralizing the polymerized or copolymerized product by acid treatment. As such a cationic polymer, polyallylamine is suitable from the viewpoint of film formability and the like.

On the other hand, the anionic polymer is a polymer having, in the molecule, an anionic functional group that can be negatively charged in water, for example, a carboxylic acid group, a sulfonic acid group, a phosphonic acid group, or an acid salt group in which these groups are partially neutralized. The anionic polymer having such a functional group can form a hygroscopic matrix because the functional group traps water by hydrogen bonding.

The amount of the anionic functional group in the anionic polymer varies depending on the type of the functional group, but as with the cationic polymer described above, may be such an amount that the water absorption rate (JIS K-7209-1984) of the polymer is 20% or more, particularly 30 to 45% under an atmosphere of a humidity of 80%RH and 30°C.

Usable examples of the anionic polymer having a functional group as described above include those produced by polymerizing or copolymerizing at least one of anionic monomers represented by: carboxylic acid-based monomers such as methacrylic acid, acrylic acid, and maleic anhydride; sulfonic acid-based monomers such as α-halogenated vinyl sulfonic acid, styrene sulfonic acid, and vinyl sulfonic acid; phosphonic acid-based monomer such as vinyl phosphoric acid; and salts of these monomers, together with another copolymerizable monomer if appropriate, and as necessary, partially neutralizing the polymerized or copolymerized product by alkali treatment. As the anionic polymer, poly (meth)acrylic acid and a partially neutralized product thereof (for example, a product in which a part is a sodium salt) are preferable.

### Moisture Absorbing Agent

The moisture absorbing agent can transfer moisture absorbed by the ionic polymer to the moisture absorbing agent and confine the absorbed moisture in the moisture absorbing agent. In addition, the moisture absorbing agent can prevent deformation due to swelling of the ionic polymer. The moisture absorbing agent preferably has a lower ultimate humidity than that of the ionic polymer. Examples of such a moisture absorbing agent include those having an ultimate humidity of 6% or less under environmental conditions of a humidity of 80%RH and a temperature of 30°C. When the moisture absorbing agent has an ultimate humidity higher than that of the ionic polymer, confinement of moisture absorbed in the matrix is insufficient and the moisture is likely to be released. However, in a case where a moisture absorbing agent having an ultimate humidity lower than that of the ionic polymer is blended in the ionic polymer, not only moisture can be effectively trapped even in a low-humidity atmosphere, but also moisture absorbed by the ionic polymer can be captured by the moisture absorbing agent, and thus the release of moisture can be suppressed and a high moisture barrier property can be exhibited.

The moisture absorbing agent as described above generally has a water absorption rate (JIS K-7209-1984) of 50% or more in an atmosphere with a humidity of 80%RH and a temperature of 30°C, and examples thereof include inorganic and organic moisture absorbing agents.

Examples of the inorganic moisture absorbing agent include zeolite, alumina, activated carbon, clay minerals such as montmorillonite, silica gel, calcium oxide, and magnesium sulfate.

Examples of the organic moisture absorbing agent include a crosslinked product of an anionic polymer or a partially neutralized product thereof. Examples of the anionic polymer include those produced by polymerizing or copolymerizing at least one of anionic monomers represented by carboxylic acid-based monomers ((meth)acrylic acid, maleic anhydride, and the like), sulfonic acid-based monomers (halogenated vinylsulfonic acid, styrenesulfonic acid, vinylsulfonic acid, and the like), phosphonic acid-based monomers (vinyl phosphoric acid, and the like), and salts of these monomers, together with another monomer. In particular, in applications where transparency is required, the organic moisture absorbing agent is effective. For example, fine particles of crosslinked sodium poly(meth)acrylate and the like are typical organic moisture absorbing agents.

Among the moisture absorbing agents described above, a moisture absorbing agent having a small particle size is preferable (for example, average primary particle size is 100 nm or less, particularly 80 nm or less) from the viewpoint of increasing the specific surface area and exhibiting high hygroscopicity, and a moisture absorbing agent of an organic polymer having a small particle size is particularly optimal.

The moisture absorbing agent of the organic polymer has very excellent dispersibility in the matrix of the ionic polymer, and can be uniformly dispersed. Furthermore, when emulsion polymerization, suspension polymerization, or the like is employed as a polymerization method for producing the moisture absorbing agent, particles can have a fine and uniform spherical shape. Blending the moisture absorbing agent of the organic polymer to some extent or more enables very high transparency to be secured.

In addition, in the case of the organic fine moisture absorbing agent, the above-described ultimate humidity is remarkably low, and not only high hygroscopicity is exhibited, but also a volume change due to swelling can be extremely reduced by crosslinking. And thus, the organic fine moisture absorbing agent is optimal in reducing the humidity to an absolute dry state or a state close to the absolute dry state while reducing the volume change.

Examples of fine particles of such an organic moisture absorbing agent include crosslinked sodium polyacrylate fine particles (average particle size: about 70 nm), commercially available in the form of a colloidal dispersion (pH = 10.4) from Japan Exlan Co., Ltd. under the trade name of TAFTIC HU-820E.

In the present invention, the amount of the moisture absorbing agent as described above is set depending on the type of the ionic polymer from the viewpoint of sufficiently exhibiting the properties, significantly improving the moisture barrier properties, effectively reducing the dimensional change due to swelling, and securing the moisture barrier properties higher than the barrier properties exhibited by all the inorganic barrier layers included in the present gas barrier laminate over a long period of time.

For example, in a case where the moisture trapping layer (B1) is formed by dispersing the moisture absorbing agent in a cationic polymer, in general, the moisture absorbing agent is preferably present in an amount of 50 parts by weight or more, particularly 100 to 900 parts by weight, and more preferably 200 to 600 parts by weight, per 100 parts by weight of the cationic polymer. Further, in a case where the moisture trapping layer (B1) is formed by dispersing the moisture absorbing agent in an anionic polymer, the moisture absorbing agent is preferably present in an amount of 50 parts by weight or more, particularly 100 to 1300 parts by weight, and more preferably 150 to 1200 parts by weight, per 100 parts by weight of the anionic polymer.

### Crosslinking Agent

In the moisture trapping layer (B1) formed using the ionic polymer as described above, it is suitable that a crosslinked structure is introduced into the ionic polymer. When a crosslinked structure is introduced into the ionic polymer, molecules of the ionic polymer are constrained to each other by crosslinking when water is absorbed, and a volume change due to swelling (moisture absorption) is reduced, leading to improvement of mechanical strength and dimensional stability.

Such a crosslinked structure can be introduced by blending a crosslinking agent in the coating composition for forming the moisture trapping layer (B1). In particular, in the case of the anionic polymer, unlike the cationic polymer, only water is trapped by hydrogen bonding. Therefore, by introducing a network structure (crosslinked structure) of spaces suitable for moisture absorption into the matrix, the hygroscopicity can be greatly enhanced.

The crosslinking agent for introducing such a crosslinked structure is slightly different between the case of introducing a crosslinked structure into the cationic polymer and the case of introducing a crosslinked structure into the anionic polymer.

Usable examples of the crosslinking agent for the cationic polymer include a compound having a crosslinkable functional group (for example, epoxy groups) capable of reacting with a cationic group and a functional group (for example, alkoxysilyl groups) capable of forming a siloxane structure in a crosslinked structure through hydrolysis and dehydration condensation, specifically, a silane compound represented by Formula (1):

X-SiR¹ₙ(OR²)₃₋ₙ (1)

where X is an organic group having an epoxy group at a terminal thereof, R¹ and R² are each independently a methyl group, an ethyl group, or an isopropyl group, and n is 0, 1, or 2.

Such a silane compound has an epoxy group and an alkoxysilyl group as functional groups, and the epoxy group undergoes an addition reaction with the functional group (for example, NH₂) of the cationic polymer. On the other hand, the alkoxysilyl group generates a silanol group (SiOH group) by hydrolysis, forms a siloxane structure through a condensation reaction, and grows to finally form a crosslinked structure between cationic polymer chains. As a result, a crosslinked structure having a siloxane structure is introduced into the matrix of the cationic polymer.

Moreover, the cationic polymer is alkaline, and as a result, when the coating composition containing the cationic polymer is applied to form the moisture trapping layer (B 1), the addition reaction between the cationic group and the epoxy group and the dehydration condensation between the silanol groups are also rapidly promoted, and the crosslinked structure can be easily introduced.

In the present invention, as the organic group X having an epoxy group in Formula (1), a γ-glycidoxyalkyl group is representative, and for example, γ-glycidoxypropyltrtmethoxysilane or γ-glycidoxypropylmethyldimethoxysilane is suitably used as a crosslinking agent.

In addition, those in which the epoxy group in Formula (1) is an alicyclic epoxy group such as an epoxy cyclohexyl group are also suitable as the crosslinking agent. For example, when a compound having an alicyclic epoxy group such as β-(3,4-epoxycyclohexyl) ethyltrimethoxysilane is used as a crosslinking agent, an alicyclic structure is introduced into the crosslinked structure of the matrix together with a siloxane structure. The introduction of such an alicyclic structure can more effectively exhibit the function of the matrix that forms a network structure of spaces suitable for moisture absorption.

Further, for introducing an alicyclic structure into the crosslinked structure, a compound having a plurality of epoxy groups and alicyclic groups, for example, a diglycidyl ester represented by Formula (2) can be used as a crosslinking agent:

G-O(C=O)-A-(C=O)O-G (2)

where G is a glycidyl group and A is a divalent hydrocarbon group having an aliphatic ring, for example, a cycloalkylene group.

Typical examples of such diglycidyl esters are represented by Formula (2-1).

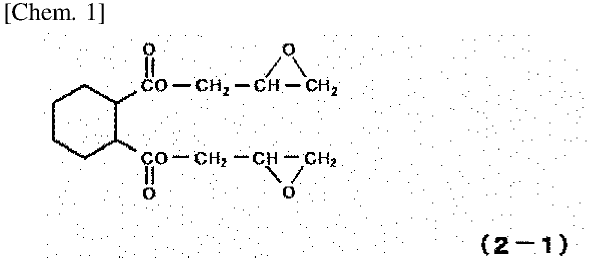

The diglycidyl ester of Formula (2) does not have an alkoxysilyl group, but introduces an alicyclic structure into the crosslinked structure, and thus is effective in that a network structure of spaces suitable for moisture absorption is formed in the matrix.

It is desirable that the crosslinking agent described above be used in an amount of 5 to 60 parts by weight, particularly 15 to 50 parts by weight, per 100 parts by weight of the cationic polymer, and it is desirable that at least 70 wt.% or more, preferably 80 wt.% or more of such a crosslinking agent be the silane compound of Formula (1) described above.

As a crosslinking agent for introducing a crosslinked structure into the anionic polymer, a compound having two or more crosslinkable functional groups (for example, epoxy groups) capable of reacting with an ionic group contained in the anionic polymer can be used as described in JP 2015-96320 A. For example, the diglycidyl ester of Formula (2), which is also mentioned in the coating composition for the cationic matrix, is suitably used:

G-O(C=O)-A-(C=O)O-G (2)

where G is a glycidyl group and A is a divalent hydrocarbon group having an aliphatic ring, for example, a cycloalkylene group.

In the diglycidyl ester of Formula (2), the epoxy group reacts with the anionic group, and a crosslinked structure including an alicyclic structure attributable to the divalent group A is formed in the matrix. The crosslinked structure including such an alicyclic structure brings about reduction of swelling.

In particular, preferred diglycidyl esters among the above diglycidyl esters have been mentioned above, and in particular, from the viewpoint that a network structure of spaces suitable for moisture absorption can be formed, the diglycidyl ester represented by Formula (2-1) is most preferred.

The moisture trapping layer (B 1) may have an anchor coat layer and a topcoat layer.

For the anchor coat layer and the topcoat layer, a known technique can be used. A layer forming the anchor coat layer is, for example, an organic layer formed of at least one selected from the group consisting of a urethane-based resin, a polyester-based resin, a polyether-based resin, an epoxy-based resin, an acrylic resin, a phenol-based resin, and a melamine-based resin, and is desirably formed of a urethane resin, an epoxy resin, or an acrylic resin. A crosslinked structure may be introduced into these resins. Further, the anchor coat layer may be an organic layer to which an inorganic filler for improving a barrier property or a silane-based compound is added. A layer forming the topcoat layer is, for example, an organic layer formed of at least one selected from the group consisting of a urethane-based resin, a polyester-based resin, a polyether-based resin, an epoxy-based resin, an acrylic resin, a phenol-based resin, and a melamine-based resin, and is desirably formed of a urethane resin, an epoxy resin, or an acrylic resin. A crosslinked structure may be introduced into these resins. Further, the topcoat layer may be an organic layer to which a metal oxide for adjusting a refractive index, an inorganic filler for improving the barrier property, or a silane-based compound is added.

Such a crosslinking agent for an anion polymer is desirably used in an amount of 1 to 50 parts by weight, particularly 10 to 40 parts by weight, per 100 parts by weight of the anionic polymer.

The moisture trapping layer (B1) is formed by applying a coating composition prepared by dissolving or dispersing a predetermined hygroscopic polymer, a moisture absorbing agent, or the like in an organic medium, heating the coating composition to form a film, and then holding the film in a dry atmosphere under reduced pressure to release moisture present in the formed layer.

Alternatively, the moisture trapping layer (B1) may be formed by applying the coating composition as described above to another organic film, forming the moisture trapping layer (B1) in the same manner, and then bonding the moisture trapping layer (B1) to the substrate layer (A1) using a dry laminate adhesive or the like.

### Moisture Trapping Layer (B2)

In the present invention, as shown in (3), (4), (6), and (8) of the aspect α described below, (3), (4), (6), and (8) of the aspect β described below, and (3) to (8) and (11) to (12) of the aspect γ described below, the moisture trapping layer (B2) can be further included on a surface of the substrate layer (A1) remote from the moisture trapping layer (B1).

The moisture trapping layer (B2) is not particularly limited as long as it exhibits a moisture blocking property, and may be a layer known per se, such as a layer produced by dispersing a moisture absorbing agent such as zeolite in a predetermined resin layer. Further, the moisture trapping layer (B2) may be a layer of the same material as the moisture trapping layer (B1). Both the moisture trapping layer (B1) and the moisture trapping layer (B2) preferably contain a resin composition in which a moisture absorbing agent (ii) is dispersed in a cationic polymer (i).

The moisture trapping layer (B2) may have an anchor coat layer and a topcoat layer. For the anchor coat layer and the topcoat layer, a known technique can be used. A layer forming the anchor coat layer is, for example, an organic layer formed of at least one selected from the group consisting of a urethane-based resin, a polyester-based resin, a polyether-based resin, an epoxy-based resin, an acrylic resin, a phenol-based resin, and a melamine-based resin, and is desirably formed of a urethane resin, an epoxy resin, or an acrylic resin. A crosslinked structure may be introduced into these resins. Further, the anchor coat layer may be an organic layer to which an inorganic filler for improving a barrier property or a silane-based compound is added. A layer forming the topcoat layer is, for example, an organic layer formed of at least one selected from the group consisting of a urethane-based resin, a polyester-based resin, a polyether-based resin, an epoxy-based resin, an acrylic resin, a phenol-based resin, and a melamine-based resin, and is desirably formed of a urethane resin, an epoxy resin, or an acrylic resin. A crosslinked structure may be introduced into these resins. Further, the topcoat layer may be an organic layer to which a metal oxide for adjusting a refractive index, an inorganic filler for improving the barrier property, or a silane-based compound is added.

### Plastic Layer (C)

As the plastic layer (C), a layer having the material and the thickness described in the section of the plastic layer (x) can be employed. A material of the plastic layer (C) may be the same as or different from that of the plastic layer (x) described above. A thickness of the plastic layer (C) may be the same as or different from that of the plastic layer (x) described above. The plastic layer (C) preferably contains an olefin-based resin, a polyester resin, a polyimide resin, a polyamide resin, or a cyclic olefin-based resin.

### Adhesive Layer (D)

The multilayer film of the present invention preferably further includes the adhesive layer (D) on a surface of the moisture trapping layer (B1) adjacent the plastic layer (C).

As the adhesive layer (D), a known adhesive such as a (meth)acrylic adhesive or a urethane-based adhesive can be used, and the adhesive layer (D) having a certain thickness or less (for example, 30 µm or less) is only required to be formed using these adhesives. In addition, ethylene-vinyl acetate copolymer (EVA), soft polyolefin (LLDPE), metallocene polyolefin-based elastomer, or the like can also be used as the adhesive.

The adhesive is preferably adjusted to have an adhesive force of 0.3 N/25 mm or more with respect to the surface of the moisture trapping layer (B 1). Note that the adhesive force can be adjusted by introducing a crosslinked structure into the polymer forming the adhesive depending on the material of the surface of the moisture trapping layer (B 1). Alternatively, it can be adjusted by blending a lubricant or the like into the adhesive.

### Production of Multilayer Film

The multilayer film of the present invention can be produced by:
(1) forming a layer selected from the group consisting of an inorganic barrier layer (a1) and an inorganic barrier layer (a2) on at least one surface of a plastic layer (x) by vapor deposition to form a substrate layer (A1);
(2) coating the substrate layer (A1) with a resin composition for forming a moisture trapping layer (B 1) and then curing the resin composition; and
(3) coating the produced multilayer film with an adhesive for forming an adhesive layer (D), and then laminating an outer layer (Q).

The plastic layer (x), the vapor deposition, the inorganic barrier layers (a), the substrate layer (A1), the moisture trapping layer (B1), the adhesive layer (D), and the outer layer (Q) are as described above.

### Application

The multilayer film of the present invention is used as a sealing material for an electronic device. For example, a pressure sensitive adhesive or the like can be used to affix the multilayer film to a device and seal the device to keep the inside of the device dry. Alternatively, the multilayer film of the present invention is used as a substrate of an electronic device by directly laminating the electronic device on the multilayer film.

The electronic device to which the multilayer film of the present invention is applied is not particularly limited, and the multilayer film can be applied to various electronic devices such as an organic EL element, a solar cell, a touch panel, and an electronic panel, in particular, an organic device which dislikes leakage of electric charges due to moisture.

### Layer Configuration

The substrate layer (A1) has the following aspects.

Aspect α: an aspect in which the inorganic barrier layer (a1) is provided on a surface remote from the moisture trapping layer (B1).

Aspect β: an aspect in which the inorganic barrier layer (a2) is provided on a surface adjacent the moisture trapping layer (B 1).

Aspect γ: an aspect including the aspect (α) and the aspect (β), that is, an aspect in which the inorganic barrier layer (a1) is provided on the surface remote from the moisture trapping layer (B 1), and the inorganic barrier layer (a2) is provided on the surface adjacent the moisture trapping layer (B 1).

Examples of the layer configuration of the multilayer film of the present invention in a case where the substrate layer (A1) of the aspect α is used are as follows. Examples of the outer layer (Q) include the plastic layer (C) of (1) to (4), the substrate layer (A1) of (5) to (6), that is, a1/x, and the substrate layer (A2) of (7) to (8), that is, a4/y.
(1) a1/x/B1/D/C
(2) a1/xB1/D/a3/C
(3) B2/a1/x/B1/D/C
(4) B2/a1/x/B1/D/a3/C
(5) a1/xB1/D/a1/x
(6) B2/a1/xB1/D/a1/x
(7) a1/xB1/D/a4/y
(8) B2/a1/x/B1/D/a4/y

Examples of the layer configuration of the multilayer film of the present invention in a case where the substrate layer (A1) of the aspect β is used are as follows. Examples of the outer layer (Q) include the plastic layer (C) of (1) to (4), the substrate layer (A1) of (5) to (6), that is, a1/x, and the substrate layer (A2) of (7) to (8), that is, a4/y.
(1) x/a2/B 1/D/C
(2) x/a2/B1/D/a3/C
(3) B2/x/a2/B1/D/C
(4) B2/x/a2/B1/D/a3/C
(5) x/a2/B1/D/a1/x
(6) B2/x/a2/B1/D/a1/x
(7) x/a2/B 1/D/a4/y
(8) B2/x/a2/B1/D/a4/y

Examples of the layer configuration of the multilayer film of the present invention in a case where the substrate layers A of the aspect γ are used are as follows. Examples of the outer layer (Q) include the plastic layer (C) of (1) to (6), the substrate layer (A2) of (7) to (8), that is, a4/y, and the substrate layer (A1) of (9) to (12), that is, a1/x.
(1) a1/x/a2/B11/D/C
(2) a1/x/a2/B11/D/a3/C
(3) B2/a1/x/a2/B1/D/C
(4) B2/a1/x/a2/B1/D/a3/C
(5) a5/z/D/B2/a1/x/a2/B1/D/C
(6) z/a5/D/B2/a1/x/a2/B1/D/C
(7) a5/z/D/B2/a1/x/a2/B1/D/a4/y
(8) z/a5/D/B2/a1/x/a2/B1/D/a4/y
(9) a1/x/a2/B11/D/a1/x
(10) B2/a1/x/a2/B1/D/a1/x
(11) a5/z/D/B2/a1/x/a2/B1/D/a1/x
(12) z/a5/D/B2/a1/x/a2/B1/D/al/x

In the above layer configuration, each brevity code is as follows.
A1: substrate layer (a1/x, x/a2, or a1/x/a2)
A2: substrate layer (a4/y)
A3: substrate layer (a5/z or z/a5)
x: plastic layer
y: plastic layer
z: plastic layer
a1: inorganic barrier layer
a2: inorganic barrier layer
a3: inorganic barrier layer
a4: inorganic barrier layer
a5: inorganic barrier layer
B1: moisture trapping layer
B2: moisture trapping layer
C: plastic layer

The multilayer film of the present invention is not limited to the above-described layer structure, and for example, a plurality of multilayer films having the above-described layer structure may be bonded to each other.

### Example

Excellent performance of the gas barrier multilayer film (multilayer film) of the present invention will be described by the following Examples.

### Measurement of Moisture Permeability (g/m²/day)

A moisture vapor permeability was measured under conditions of a temperature of 40°C and a relative humidity of 90% using a water vapor transmission rate measuring apparatus "HiBarSens 2.0 (SEMPA SYSTEMS GmbH, Germany)". In this apparatus, measurement was performed with modes switched depending on barrier performance of a measurement sample. Measurement of a moisture vapor transmission rate of 1 × 10⁻⁴ g/m²/day or more was performed in Carrier Gas mode, and measurement of less than 1 × 10⁻⁴ g/m²/day was performed in Combination mode suitable for measurement with higher sensitivity to accurately evaluate high barrier performance.

### Preparation of Coating Liquid A

Polyallylamine (PAA-15C, available from Nittobo Medical Co., Ltd., aqueous solution product, solid content: 15%) as an ionic polymer was diluted with water to have a solid content of 5 wt.%, thereby producing a polymer solution. On the other hand, γ-glycidoxypropyltrimethoxysilane was used as a crosslinking agent, and dissolved in water to be 5 wt.% to prepare a crosslinking agent solution. Next, the polymer solution and the crosslinking agent solution were mixed such that the amount of γ-glycidoxypropyltrimethoxysilane was 15 parts by weight with respect to 100 parts by weight of polyallylamine, and further, a crosslinked product of sodium polyacrylate (TAFTIC HU-820E available from Japan Exlan, Co., Ltd., water-dispersed product, solid content: 13%, average particle size D₅₀: 70 nm) as a granular moisture absorbing agent was added to the mixed solution to be 400 parts by weight with respect to polyallylamine, and the resulting mixture was further adjusted with water to have a solid content of 5%, and then well stirred to prepare a coating liquid A for a moisture trapping layer.

### Example 1

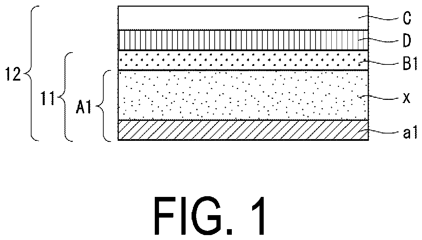

A 100 µm-thick biaxially stretched polyethylene terephthalate (PET) film was used as a plastic layer (x) (x in FIG. 1), and an inorganic barrier layer (a1) of silicon oxide (a1 in FIG. 1) was formed on one surface of the plastic layer (x) using a plasma CVD apparatus to produce a substrate layer (A1) (A1 in FIG. 1). The film forming conditions are indicated below.

A CVD apparatus having a high-frequency oscillator having a frequency of 27.12 MHz, a matching box, a metallic cylindrical plasma treatment chamber with a diameter of 300 mm and a height of 450 mm, and an oil-sealed rotary vacuum pump for evacuating the treatment chamber was used. A plastic substrate was placed on parallel flat plates in the treatment chamber, 3 sccm of hexamethyldisiloxane and 45 sccm of oxygen were introduced thereto. Then, high-frequency waves were oscillated with an output of 50 W by the high-frequency oscillator to form a film for 2 seconds, thereby forming an adhesion layer. Next, high-frequency waves were oscillated with an output of 500 W by the high-frequency oscillator to form a film for 30 seconds, thereby forming an inorganic barrier layer (a1). The substrate layer (A1) (A1 in FIG. 1), which was the produced inorganic barrier layer-coated PET film, had a moisture permeability of 2 × 10⁻⁴ g/m²/day measured in an atmosphere with 40°C and 90%RH.

The coating liquid A prepared under the conditions described above was applied, using a bar coater, onto the PET surface of the substrate layer (A1) (A1 in FIG. 1) having the inorganic barrier layer (a1) formed in advance. The film after applying was heat-treated in a box-type electric oven under conditions of a peak temperature of 120°C and a peak temperature holding time of 10 seconds to form a 4 µm-thick moisture trapping layer (B1) (B1 in FIG. 1), thereby producing a coating film (i) (11 in FIG. 1).

Next, the produced coating film (i) was quickly transferred into a glove box adjusted to a nitrogen concentration of 99.95% or more. A 12 µm-thick industrial PET film was used as a plastic layer (C) (C in FIG. 1) and dry-laminated on the moisture trapping layer (B1) (B1 in FIG. 1) of the coating film (i) with a 4 µm-thick urethane-based adhesive layer (D) (D in FIG. 1) interposed therebetween. For curing the adhesive layer (D) not to absorb moisture, aging was carried out at 50°C for 3 days under vacuum to produce a multilayer film 1 (12 in FIG. 1) having a layer structure as illustrated in FIG. 1.

### Example 2

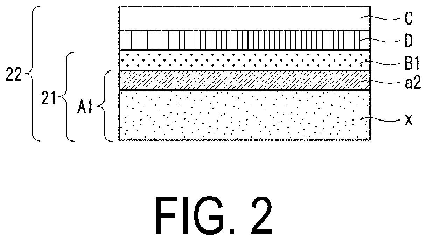

There was prepared a substrate layer (A1) having an inorganic barrier layer (a2) formed under the same conditions as in Example 1 except that the high-frequency output of the film forming conditions shown in Example 1 was changed to 300 W. The produced substrate layer (A1) (A1 in FIG. 2) had a moisture permeability of 8 × 10⁻⁴ g/m²/day as measured in an atmosphere with 40°C and 90%RH. A multilayer film 2 (22 in FIG. 2) was produced in the same manner as in Example 1 except that a coating film (ii) (21 in FIG. 2) produced by coating the coating liquid A onto the inorganic barrier layer (a2) of the substrate layer (A1) remote from the PET using a bar coater was used instead of the coating film (i) shown in Example 1.

### Example 3

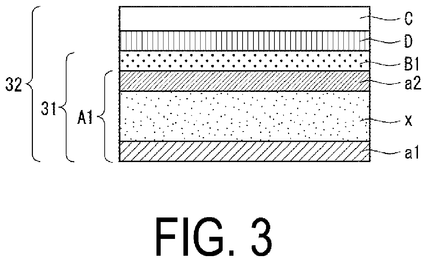

A biaxially stretched PET film having a thickness of 100 µm was used as the plastic layer (x). On respective surfaces of the plastic layer (x), using a plasma CVD apparatus, an inorganic barrier layer (a1) of silicon oxide was formed under the film forming conditions of Example 1 and an inorganic barrier layer (a2) of silicon oxide was formed under the film forming conditions of Example 2, respectively, thereby producing a substrate layer (A1). The produced substrate layer (A1) (A1 in FIG. 3) had a moisture permeability of 9 × 10⁻⁵ g/m²/day as measured in an atmosphere with 40°C and 90%RH. A coating film (iii) (31 in FIG. 3) in which the inorganic barrier layer (a2) was coated with the coating liquid A by a bar coater to form the moisture trapping layer (B1) was used and a 12 µm-thick PET film as the plastic layer (C) was dry-laminated on the moisture trapping layer (B1) (B1 in FIG. 3) with the adhesive layer (D) interposed therebetween in the same manner as in Example 1 to produce a multilayer film 3 (32 in FIG. 3).

### Example 4

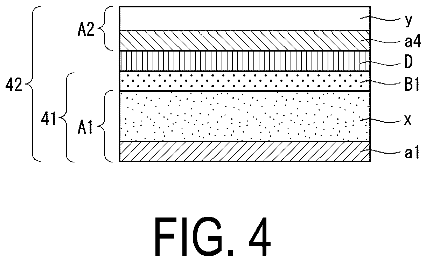

A multilayer film 4 (42 in FIG. 4) was produced in the same manner as in Example 1 except that a side of the inorganic barrier layer (a4) of a commercially available barrier film (TECHBARRIER LS available from Mitsubishi Chemical Corporation) having a moisture permeability of 0.15 g/m²/day in an atmosphere with 40°C and 90%RH was dry-laminated on the moisture trapping layer (B1) of the coating film (i) (41 in FIG. 4), as the substrate layer (A2) instead of the 12 µm-thick PET film used for the plastic layer (C) in Example 1.

### Example 5

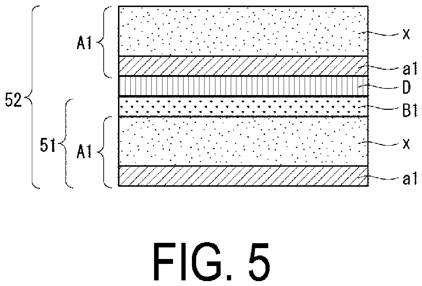

A multilayer film 5 (52 in FIG. 5) was produced in the same manner as in Example 1 except that two substrate layers (A1) produced in Example 1 were used, one of them was used instead of the 12 µm-thick PET film used for the plastic layer (C) in Example 1, a side of the inorganic barrier layer (a1) of the substrate layer (A1) was dry-laminated on the moisture trapping layer (B1) of the coating film (i) (51 in FIG. 5) with the adhesive layer (D) interposed therebetween.

### Comparative Example 1

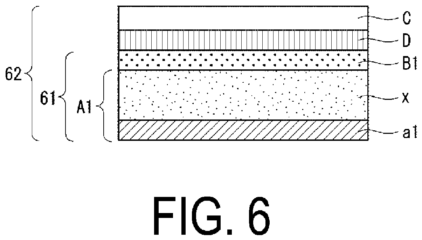

A multilayer film 6 (62 in FIG. 6) was produced in the same manner as in Example 1 except that the moisture permeability of the substrate layer (A1) (A1 in FIG. 6) prepared under the same conditions as in Example 1 except that the high-frequency output of the film forming conditions shown in Example 1 was changed to 300 W was 2.1 × 10⁻³ g/m²/day in an atmosphere with 40°C and 90%RH.

### Evaluation Test

The moisture permeability of each of the laminates of the samples prepared above was measured in an atmosphere with 40°C and 90%RH by the above-described method, and the results are shown in Table 1. In Examples 1 to 5, unlike Comparative Example 1, the moisture permeability of the multilayer film in an atmosphere with 40°C and 90%RH was less than 1 × 10⁻⁶ g/m²/day.

**[Table 1]**

| | Substrate layer (A1) | | Gas barrier multilayer film | |
|---|---|---|---|---|
| | Name | Moisture permeability (40°C, 90%RH) (g/m²/day) | Name | Moisture permeability (40°C, 90%RH) (g/m²/day) |
| Example 1 | Substrate layer (A1) | 2.0 × 10⁻⁴ | Gas barrier multilayer film 1 | Less than 1 × 10⁻⁶ |
| Example 2 | Substrate layer (A1) | 8.0 × 10⁻⁴ | Gas barrier multilayer film 2 | Less than 1 × 10⁻⁶ |
| Example 3 | Substrate layer (A1) | 9.0 × 10⁻⁵ | Gas barrier multilayer film 3 | Less than 1 × 10⁻⁶ |
| Example 4 | Substrate layer (A1) | 2.0 × 10⁻⁴ | Gas barrier multilayer film 4 | Less than 1 × 10⁻⁶ |
| Example 5 | Substrate layer (A1) | 2.0 × 10⁻⁴ | Gas barrier multilayer film 5 | Less than 1 × 10⁻⁶ |
| Comparative Example 1 | Substrate layer (A1) | 2.1 × 10⁻³ | Gas barrier multilayer film 6 | 9 × 10⁻⁶ |

### Reference Signs List

11 Coating film (i)
12 Gas barrier multilayer film 1
21 Coating film (ii)
22 Gas barrier multilayer film 2
31 Coating film (iii)
32 Gas barrier multilayer film 3
41 Coating film (iv)
42 Gas barrier multilayer film 4
51 Coating film (v)
52 Gas barrier multilayer film 5
61 Coating film (vi)
62 Gas barrier multilayer film 6
A1 Substrate layer
A2 Substrate layer
x Plastic layer
y Plastic layer
a1 Inorganic barrier layer
a2 Inorganic barrier layer
a4 Inorganic barrier layer
B1 Moisture trapping layer
C Plastic layer
D: Adhesive layer

## Claims

1. A gas barrier multilayer film comprising:
a substrate layer (A1), a moisture trapping layer (B 1), and an outer layer (Q) in this order, wherein
the substrate layer (A1) has a layer selected from the group consisting of an inorganic barrier layer (a1) and an inorganic barrier layer (a2) on at least one surface of a plastic layer (x), and
the substrate layer (A1) has a moisture permeability (40°C, RH90%) of less than 1 × 10⁻³ g/m²/day.

2. The gas barrier multilayer film according to claim 1, wherein
the substrate layer (A1) comprises
(α) an inorganic barrier layer (a1) on a surface remote from the moisture trapping layer (B1),
(β) an inorganic barrier layer (a2) on a surface adjacent the moisture trapping layer (B1), or
(γ) the (α) and the (β).

3. The gas barrier multilayer film according to claim 1 or 2, wherein the outer layer (Q) is a layer selected from the group consisting of a plastic layer (C), the substrate layer (A1) and a substrate layer (A2), and the substrate layer (A2) is a layer having an inorganic barrier layer (a4) on one surface of a plastic layer (y).

4. The gas barrier multilayer film according to claim 1 or 2, further comprising a moisture trapping layer (B2) on a surface of the substrate layer (A1) remote from the moisture trapping layer (B 1).

5. The gas barrier multilayer film according to claim 4, further comprising an adhesive layer (D) and a substrate layer (A3) in this order on a surface of the moisture trapping layer (B2) remote from the substrate layer (A1), wherein the substrate layer (A3) is a layer having an inorganic barrier layer (a5) on one surface of a plastic layer (z).

6. The gas barrier multilayer film according to any one of claims 1 to 5, further comprising an inorganic barrier layer (a3) of the plastic layer (C) adjacent the moisture trapping layer (B1).

7. The gas barrier multilayer film according to any one of claims 1 to 6, further comprising the adhesive layer (D) on a surface of the moisture trapping layer (B1) adjacent the outer layer (Q).

8. The gas barrier multilayer film according to any one of claims 1 to 7, wherein the inorganic barrier layers (a1) to (a5) are metal-oxide films.

9. The gas barrier multilayer film according to any one of claims 1 to 8, wherein the plastic layers (x) to (z) contain an olefin-based resin, a polyester resin, a polyimide resin, a polyamide resin, or a cyclic olefin-based resin.

10. The gas barrier multilayer film according to any one of claims 1 to 9, wherein both the moisture trapping layer (B1) and the moisture trapping layer (B2) contain a resin composition in which a moisture absorbing agent (ii) is dispersed in an ionic polymer (i).

11. The gas barrier multilayer film according to any one of claims 1 to 10, wherein the plastic layer (C) includes an olefin-based resin, a polyester resin, a polyimide resin, a polyamide resin, or a cyclic olefin-based resin.
